# EUROPÄISCHE PATENTSCHRIFT

(11) **EP 3 734 646 B1**
(45) Veröffentlichungstag und Bekanntmachung des Hinweises auf die Patenterteilung: **15.01.2025**
(21) Anmeldenummer: 20168143.4
(22) Anmeldetag: 06.04.2020
(51) Int. Cl.: H01L 21/48, H01L 23/473

(54) **HALBLEITERBAUTEIL, KRAFTFAHRZEUG UND VERFAHREN ZUR HERSTELLUNG EINES HALBLEITERBAUTEILS**
SEMICONDUCTOR COMPONENT, MOTOR VEHICLE AND METHOD FOR PRODUCING A SEMICONDUCTOR COMPONENT
COMPOSANT SEMI-CONDUCTEUR, VÉHICULE AUTOMOBILE ET PROCÉDÉ DE FABRICATION D'UN COMPOSANT SEMI-CONDUCTEUR

(30) Priorität: 02.05.2019 DE 102019206262
(43) Veröffentlichungstag der Anmeldung: 04.11.2020
(73) Patentinhaber: Audi AG, 85045 Ingolstadt (DE); Hitachi Energy Ltd, 8050 Zürich (CH)
(72) Erfinder: Gradinger, Thomas, 5032 Aarau Rohr (CH); Torresin, Daniele, 5400 Baden (CH)

(56) Entgegenhaltungen:
- WO-A1-2017/069005
- WO-A1-2018/123387
- DE-A1- 102016 110 043
- JP-A- 2006 222 461
- JP-A- 2008 159 946
- US-A1- 2009 194 862
- US-A1- 2012 305 281
- US-A1- 2016 183 409

## Beschreibung

Die Erfindung betrifft ein Verfahren zur Herstellung eines Halbleiterbauteils, das die folgenden Schritte umfasst:
- Bereitstellen wenigstens eines Halbleitermoduls und eines Tragrahmens, der für jedes der Halbleitermodule eine jeweilige Durchbrechung aufweist,
- Anordnen des wenigstens eine Halbleitermoduls an dem Tragrahmen derart, dass eine Grundplatte des jeweiligen Halbleitermoduls auf dem Rand der jeweiligen Durchbrechung aufliegt,
- Verlöten der jeweiligen Grundplatte mit dem Tragrahmen, wobei die jeweilige Grundplatte mit einem Lot mit einem Schmelzpunkt von wenigstens 450°C mit dem Tragrahmen verlötet wird.

Zum Antrieb einer dreiphasigen Elektromaschine mit Hilfe von Gleichstrom beziehungsweise zur Bereitstellung von Gleichstrom mit Hilfe eines dreiphasigen Generators können dreiphasige Wechsel- beziehungsweise Gleichrichter genutzt werden, die durch Halbleiterschalter gebildet werden. Hierbei ist es möglich, die gesamte Brückenschaltung als gekapseltes Bauteil auszubilden, das anschließend beispielsweise auf einem Kühlkörper oder ähnlichem montiert werden kann. Der Aufbau der gesamten Brückenschaltung als einzelnes Modul stellt jedoch, wenn die einzelnen Halbleiterkomponenten durch Sintern mit einem Substrat verbunden werden sollen, ein relativ großes wirtschaftliches Risiko dar, da die einzelnen Komponenten hierbei nicht separat gebondet und getestet werden können. Der beim Sintern auftretende Druck würde entsprechende Drahtbondverbindungen typischerweise zerstören.

Werden kleinere Baugruppen genutzt kann es jedoch relativ aufwendig sein, eine gemeinsame Kühlung für alle Halbleiterschalter bereitzustellen. Beispielsweise werden bei der in der Druckschrift US 2003/0053298 A1 offenbarten Kühlung von elektrischen Bauteilen die Bauteile tragende Basisplatten mit einer Komponente, die die Kühlkanäle ausbildet, verschweißt. Aufgrund der hohen bei einem Schweißvorgang auftretenden Temperaturen sollten die Schweißstellen jedoch relativ weit von empfindlichen Halbleiterkomponenten entfernt sein, so dass der resultierende Aufbau unter Umständen unnötig großbauend sein kann beziehungsweise ein relativ komplexer Aufbau erforderlich ist. Zudem ist es relativ aufwendig, sicher zu stellen, dass Schweißverbindungen auf ihrer gesamten Länge fluiddicht sind.

Die Druckschrift DE 10 2016 110 043 A1 betrifft eine flüssigkeitsgekühlte Kühleinrichtung, die dazu dient, einen wärmeerzeugenden Körper, beispielsweise ein Halbleiterbauteil, zu kühlen. Die Kühleinrichtung umfasst ein Gehäuse, durch das Kältemittel fließt, und einen Kühlkörper, der an dem Gehäuse befestigt ist. Der Kühlkörper liegt auf einem Rand des wannenförmigen Gehäuses auf. Die Verbindung mit diesem Rand kann durch Löten erfolgen.

Eine Kühlvorrichtung für ein Halbleitermodul, bei der eine Elektrode des Halbleitermoduls in eine Ausnehmung eines Deckels eines Kühlkanals eingesetzt ist und hierdurch eine Durchbrechung des Deckels verschließt ist aus der

Druckschrift JP 2008 159946 A bekannt. Die Verbindung erfolgt durch eine Schicht aus Hartlötmaterial. Das Hartlöten erfolgt dadurch, dass das zunächst folienartige Hartlötmaterial in einem Vakuumofen aufgeschmolzen wird.

Die Druckschrift WO 2017/069005 A1 offenbart ein Verfahren zur Herstellung eines Halbleitermoduls, bei dem ein Kühlkörper in eine Ausnehmung eines Gehäuses eingreift. Die Verbindung erfolgt durch ein Lötmittel, das gemäß der Zusammenfassung aufgeschmolzen wird, indem ein metallischer Abschnitt des Gehäuses durch Induktion beheizt wird.

Die Druckschrift US 2009/194862 A1 betrifft ein Halbleitermodul mit daran angebrachtem Kühlkanal. Das den Kühlkanal begrenzende Gehäuse ist mit der Kühlplatte über ein Lötmittel verbunden.

Die Druckschrift JP 2006 222461 A betrifft eine Vorrichtung zum Abführen von Hitze, bei der in einem Ausführungsbeispiel zwischen einem isolierenden Substrat und einem Deckel eines Gehäuses eine Schicht aus Hartlötmaterial angeordnet ist.

Die Druckschrift US 2016/0183409 A1 betrifft Leistungselektronikmodule, die in Ausnehmungen eines modularen Kühlsystems eingesetzt sind. Eine Wärmetransferplatte des jeweiligen Leistungselektronikmoduls wird jeweils am Rand einer Ausnehmung befestigt. Bezüglich der Befestigung werden verschiede Möglichkeiten genannt, beispielsweise eine mechanische Befestigung, die beispielsweise durch einen O-Ring abgedichtet sein kanr Löten, Hartlöten und Ultraschallschweißen.

Die Druckschrift WO 2018/123387 A1 betrifft ein Verfahren zur Herstellung eines Wärmetauschers für einen Flüssigkeitskühler. Die Verbindung einer oberen Wanne mit einem Boden kann durch ein Hartlötmaterial erfolgen.

Die Druckschrift US 2012/0 305 281 A1 betrifft ein Verfahren zur Verbindung eines metallisierten Keramiksubstrats mit einem Metallkörper. Zwischen diesen beiden Komponenten wird eine Aluminium enthaltende Metalllegierung mit einem Schmelzpunkt von mehr als 450°C angeordnet und diese gesamte Anordnung wird in einem Lötofen auf eine Temperatur von mehr als 450°C erhitzt. Als Alternative zur Nutzung eines Lötofens werden Plasmalöten, Laserlöten, Flammlöten und Induktionslöten erwähnt. Elektrische Komponenten, beispielsweise Halbleiterbauteile, werden erst nach der Verbindung des Keramiksubstrats mit dem Metallkörper auf dem Keramiksubstrats angeordnet.

Der Erfindung liegt somit die Aufgabe zugrunde, ein demgegenüber verbessertes Verfahren zum Aufbau eines Halbleiterbauteils anzugeben, das mehrere Halbleitermodule umfassen kann.

Die Aufgabe wird erfindungsgemäß durch ein Verfahren eingangs genannter Art gelöst, wobei das Verlöten der jeweiligen Grundplatte mit dem Tragrahmen durch Laserhartlöten erfolgt, wobei der Laser hierbei auf die von der Grundplatte abgewandte Seite des Tragrahmens eingestrahlt wird, wodurch der Tragrahmen lokal erhitzt und das Lot durch den erhitzten Tragrahmen aufgeschmolzen wird, wobei im Rahmen des Verlötens der jeweiligen Grundplatte mit dem Tragrahmen das Material des Tragrahmens lokal geschmolzen wird.

Gegenüber einem Verschweißen von Komponenten kann bei einer Lötverbindung, auch bei einem Hartlöten, mit erheblich geringeren Temperaturen gearbeitet werden, indem ein Lot mit passendem Schmelzpunkt gewählt wird In dem erfindungsgemäßen Verfahren liegen zudem die Grundplatte und der Tragrahmen in einem verlöteten Bereich vorzugsweise flächig aufeinander, so dass das verflüssigte Lot durch die zwischen den beiden aufeinanderliegenden plattenförmigen Bereichen wirkende Kapillarwirkung in den Zwischenraum eingesogen wird. Hierdurch wird mit einfachen Mitteln eine robuste Fluiddichtigkeit erreicht. Dies kann, wie später noch genauer erläutert werden wird, dazu genutzt werden, einen Fluidkanal zum Führen von beispielsweise flüssigem Kühlmittel durch die Grundplatte und den Tragrahmen gemeinsam abzudichten. Hierdurch kann eine sehr gute Kühlung der einzelnen Halbleitermodule erreicht werden. Anders ausgedrückt wird vorgeschlagen, die Grundplatte und der Tragrahmen durch ein dazwischen angeordnetes Lot stoffschlüssig zu verbinden. Die Verlötung erfolgt durch Laserhartlöten. Die Grundplatte trägt insbesondere ein Substrat, das wiederum die Halbleiterkomponenten, z. B. Halbleiterchips, trägt.

Die Halbleitermodule liegen insbesondere umfangsseitig auf allen Seiten mit ihrem Rand auf dem Rand der Durchbrechung auf. Durch ein allseitiges Verlöten kann somit die Durchbrechung durch die jeweilige Grundplatte vollständig verschlossen werden, was wie obig erläutert, insbesondere dazu dienen kann, einen Kühlkanal auszubilden. Die Grundplatte kann zumindest in einem Abschnitt jenes Bereiches, in dem sie auf dem Rand der Aufnehmung aufliegt, mit dem Tragrahmen verlötet sein. Es wird somit eine Überlappverbindung genutzt.

Ein Abschnitt der Grundplatte, in dem die Grundplatte mit dem Tragrahmen verlötet ist, kann sich vollständig um einen Bereich der Grundplatte erstrecken, in dem die Grundplatte Vorsprünge aufweist, die sich durch die jeweilige Durchbrechung des Tragrahmens hindurch erstrecken und er kann sich vollständig um die jeweilige Durchbrechung des Tragrahmens herum erstrecken. Die Vorsprünge der Grundplatte können insbesondere Kühlfinnen sein, die bei einem Betrieb des Halbleiterbauteils vorzugsweise dauerhaft in Kontakt mit Kühlfluid stehen. Beispielsweise können diese Kühlfinnen beziehungsweise Vorsprünge in einen Kühlkanal hineinragen, der das Kühlfluid, beispielsweise eine Kühlflüssigkeit, führt. Durch das Umgreifen des Bereichs, in dem die Kühlfinnen angeordnet sind beziehungsweise der vollständigen Durchbrechung kann sichergestellt werden, dass die Durchbrechung durch die Grundplatte und die Lötverbindung gemeinsam vollständig abgedichtet wird.

Durch den Tragrahmen, die jeweilige Grundplatte des wenigstens einen Halbleitermoduls und ein Verschlusselement kann ein Fluidkanal ausgebildet werden, der abgesehen von einem Kühlfluidzufluss und einem Kühlfluidabfluss allseitig fluiddicht verschlossen ist. Beispielsweise kann der Fluidkanal bezüglich eines bestimmten Kühlfluids, beispielsweise Wasser oder Öl, fluiddicht sein. Das Verschlusselement kann somit eine Art Deckel für den Kühlkanal bilden, wobei das Verschlusselement insbesondere den Kühlfluidzufluss und den Kühlfluidabfluss ausbilden kann und allseitig in einem Randbereich mit einem Randbereich des Tragrahmens verbunden sein kann oder Ähnliches.

Das Verschlusselement kann mit dem Tragrahmen verlötet oder verschweißt sein. Wie obig erläutert kann durch ein Verlöten besonders einfach und bei relativ niedrigen Temperaturen eine fluiddichte Verbindung hergestellt werden. Da die Verbindungsstelle jedoch typischerweise von den Halbleiterkomponenten des Halbleiterbauteils beziehungsweise der Halbleitermodule weiter entfernt ist als die Verbindungsstelle des Tragrahmens zu der Grundplatte, können auch höhere Temperaturen genutzt werden und es kann ein Verschweißen erfolgen.

Die Grundplatte wird mit dem Tragrahmen mit einem Lot mit einem Schmelzpunkt von wenigstens 450° C verlötet. Anders ausgedrückt werden die Grundplatte und der Tragrahmen durch Laserhartlöten verbunden . Hierdurch kann eine besonders robuste Verbindung erreicht werden, wobei dennoch niedrigere Temperaturen zur Verbindung erforderlich sind als bei einem Schweißvorgang und zudem, wie obig erläutert, leichter eine Fluiddichtheit erreicht werden kann. Das Lot kann insbesondere einen Schmelzpunkt aufweisen, der unterhalb des Schmelzpunkts der Materialien der Grundplatte und des Tragrahmens liegt. Prinzipiell kann der Lötvorgang somit durchgeführt werden, ohne dass das Material der Grundplatte beziehungsweise des Tragrahmens geschmolzen wird. Wie später noch erläutert wird, ist es jedoch auch möglich, dass diese Materialen zumindest lokal schmelzen.

Halbleiterkomponenten des jeweiligen Halbleitermoduls können durch Sintern mit der Grundplatte oder einem an der Grundplatte angebrachten Substrat angebracht sein und/oder das Halbleitermodul kann durch eine Vergussmasse vergossen sein. Wie bereits eingangs erläutert ist es vorteilhaft, wenn durch Sintern hergestellte Halbleitermodule eine relativ geringe Komplexität aufweisen. Durch die erfindungsgemäße Herstellung des Halbleitermoduls können eine Mehrzahl separat aufgebauter Halbleitermodule mit geringem Aufwand zu einem Halbleiterbauteil zusammengefasst werden, das gut kühlbar ist. Daher können gesinterte Halbleitermodule mit relativ geringer Komplexität genutzt werden.

Ein Vergießen der einzelnen Halbleitermodule kann beispielsweise durch Spritzpressen, auch Resin Transfer Moulding genannt, erfolgen, jedoch auch beispielsweise durch Spritzguss oder Ähnliches. Insbesondere wird kein separates Gehäuse mit einem Substrat beziehungsweise der Grundplatte verklebt, sondern das Halbleitermodul wird, insbesondere nach dem Versintern der einzelnen Komponenten oder einem Bonden der einzelnen Komponenten, direkt vergossen. Die Vergussmasse kann das Halbleitermodul abgesehen von freiliegenden Kontaktflächen und einer freien Seitenfläche der Grundplatte allseitig abschließen. Dabei können die Kontaktflächen insbesondere nach außengeführte Kontakte sein.

Das Halbleitermodul kann insbesondere wenigstens einen Halbleiterchip umfassen, der auf einem Substrat oder auf der Grundplatte angeordnet ist. Die von dem Halbleiterchip abgewandte Seite des Substrats kann mit der Grundplatte verbunden sein. Die von dem Substrat beziehungsweise dem Halbleiterchip abgewandte Seite des Substrats kann umfangsseitig einen Randbereich aufweisen, in dem sie auf dem Tragrahmen aufliegt. In einem von diesem Bereich umgebenen Innenbereich dieser Seite der Grundplatte können die Vorsprünge beziehungsweise Kühlfinnen angeordnet sein. Der auf dem Tragrahmen aufliegende Teil kann den Innenbereich vollständig umgreifen.

Der Tragrahmen kann aus Aluminium oder einer Aluminiumlegierung bestehen. Ergänzend oder alternativ kann die Grundplatte aus Kupfer oder Aluminium oder einem Verbundmaterial, bei dem Siliziumkarbidpartikel in einer Aluminiummatrix aufgenommen sind, bestehen. Wird eine Grundplatte aus Kupfer verwendet, kann diese insbesondere vernickelt sein. Wird das obig beschriebene Verbundmaterial als Grundplatte verwendet, können Bereiche, in denen ein Löten erfolgen soll, eine aluminiumreiche Schicht aufweisen, um das Herstellen einer robusten Lötverbindung zu erleichtern. Die Schichtdicke dieser aluminiumreichen Schicht kann beispielsweise 0,5 mm oder mehr sein. Durch den beschriebenen Aufbau der Grundplatte beziehungsweise des Tragrahmens kann insbesondere erreicht werden, dass das thermische Ausdehnungsverhalten der Grundplatte mit dem thermischen Ausdehnungsverhalten eines darauf angebrachten Substrats weitgehend übereinstimmt, wobei insbesondere eine gute Wärmeabfuhr erreicht werden kann.

Das Halbleitermodul kann eine Halbbrücke sein und/oder das Halbleiterbauteil kann ein, insbesondere dreiphasiger, Brückenwechselrichter oder Brückengleichrichter sein. Brückenwechselrichter oder Brückengleichrichter können bezüglich ihrer Leistungskomponenten, also bezüglich der Halbleitermodule, baugleich sein. Sie unterscheiden sich primär bezüglich der Leistungstransportrichtung und somit bezüglich der Steuerung. Das Halbleiterbauteil kann somit beispielsweise auch bedarfsgerecht als Brückengleichrichter und Brückenwechselrichter nutzbar sein.

Offenbart wird zudem ein Kraftfahrzeug, das ein durch das erfindungsgemäße Verfahren hergestellte Halbleiterbauteil umfasst. Das Halbleiterbauteil kann insbesondere ein Wechselrichter für eine elektrische Maschine des Kraftfahrzeugs, insbesondere für einen Antriebsmotor, sein. Das Halbleiterbauteil kann ergänzend oder alternativ auch dazu dienen, bei einem Generatorbetrieb der elektrischen Maschine einen Gleichstrom bereitzustellen, beispielsweise um ein Fahrzeugnetz zu speisen beziehungsweise eine Batterie des Kraftfahrzeugs zu laden.

Im Rahmen der Herstellung des Halbleiterbauteils wird wenigstens ein Halbleitermodul beziehungsweise werden vorzugsweise mehrere Halbleitermodule dadurch an dem Tragrahmen angebracht, dass sie zunächst im Bereich der Durchbrechungen platziert und anschließend ihre Grundplatte mit dem Tragrahmen im Randbereich der Durchbrechung verlötet wird. Details hierzu wurden bereits obig erläutert. Mit Bezug zu dem Halbleiterbauteil erläuterte Merkmale können mit den dort genannten Vorteilen auf das erfindungsgemäße Verfahren übertragen werden.

Erfindungsgemäß wird die Grundplatte durch Laserhartlöten mit dem Tragrahmen verlötet. Der Vorgang des Laserhartlöten ist prinzipiell im Stand der Technik bekannt und wird beispielsweise im Karosseriebau in Kraftfahrzeugen verwendet. Hierbei wird das Werkstück an einer Stelle, an der der Lötvorgang erfolgen soll, durch Einstrahlung von energiereichem Laserlicht lokal erhitzt. Durch Laserlöten können auch schmale Lötnähte mit hoher Genauigkeit bewerkstelligt werden.

Zur Herstellung des Halbleiterbauteils wird der Laser auf die von der Grundplatte abgewandte Seite des Tragrahmens eingestrahlt.

Hierdurch wird der Tragrahmen lokal erhitzt und das Lot wird durch den erhitzten Tragrahmen aufgeschmolzen. Dies kann besonders vorteilhaft sein, da eine zu starke Erhitzung von Komponenten des Halbleitermoduls hierdurch verhindert werden kann.

Wird, wie obig erläutert, ein Verschlusselement mit dem Tragrahmen verbunden, beispielsweise um eine Kühlkammer auszubilden, kann dies ebenfalls durch Laserlöten beziehungsweise Laserhartlöten erfolgen.

Das Halbleiterbauteil wird wie zum erfindungsgemäßen Verfahren erläutert hergestellt.

Die Verbindung der Grundplatte mit dem Tragrahmen und optional des Tragrahmens mit dem Verschlusselement wird in dem erfindungsgemäßen Verfahren durch Laserhartlöten, hergestellt.

Bei der erfindungsgemäßen Herstellung eines Halbleiterbauteils wird im Rahmen des Verlötens der jeweiligen Grundplatte mit dem Tragrahmen das Material des Tragrahmens lokal geschmolzen. Optional kann zusätzlich das Material der Grundplatte lokal geschmolzen werden. Insbesondere kann das Material des Tragrahmens an einer von der Grundplatte abgewandten Seite geschmolzen werden. Es ist jedoch auch möglich, dass der Tragrahmen über seine gesamte Dicke hinweg angeschmolzen wird und/oder die dem Tragrahmen zugewandte Seite der Grundplatte angeschmolzen wird. Gegenüber einer direkten stoffschlüssigen Verbindung von Tragrahmen und Grundplatte durch Schweißen wird bei dem erfindungsgemäßen Verlöten aufgrund der Kapillarwirkung zwischen Grundplatte und Tragrahmen dennoch erreicht, dass Lot zwischen diese gezogen wird und somit besonders robust eine fluiddichte Verbindung erzeugt wird.

Weitere Vorteile und Einzelheiten der Erfindung ergeben sich aus den folgenden Ausführungsbeispielen sowie den zugehörigen Zeichnungen. Hierbei zeigen schematisch:
- Fig. 1: ein Ausführungsbeispiel eines erfindungsgemäßen Halbleiterbauteils,
- Fig. 2: eine Detailansicht des in Fig. 1 dargestellten Halbleiterbauteils,
- Fig. 3: einen Zwischenschritt in einem Ausführungsbeispiel des erfindungsgemäßen Verfahrens zur Herstellung des in Fig. 1 und Fig. 2 dargestellten Halbleiterbauteils, und
- Fig. 4: ein Ausführungsbeispiel eines erfindungsgemäßen Kraftfahrzeugs.

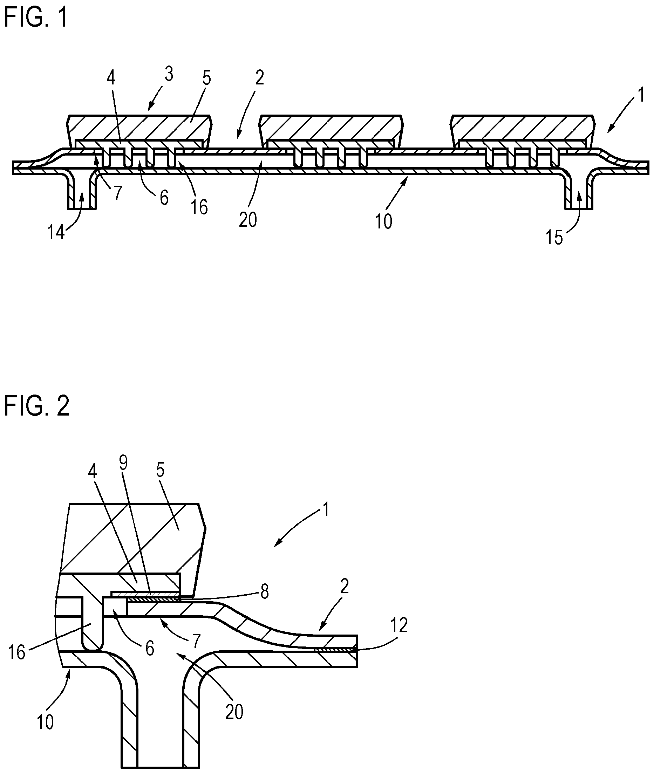

Fig. 1 zeigt ein Halbleiterbauteil 1, das beispielsweise ein dreiphasiger Brückengleichrichter oder Brückenwechselrichter sein kann. Da die nicht gezeigten einzelnen Halbleiterkomponenten durch Sintern mit einem Substrat verbunden sein sollten, kann es zweckmäßig sein, einen solchen Gleich- beziehungsweise Wechselrichter nicht als einzelnes Modul auszuführen, sondern beispielsweise drei Halbleitermodule 3 zu nutzen, die beispielsweise jeweils eine Halbbrücke implementieren können. Der interne Aufbau der einzelnen Halbleitermodule 3 sowie deren Kontaktierung sind in den Figuren aus Übersichtlichkeitsgründen nicht dargestellt. Die Herstellung von beispielsweise Halbbrücken als gesinterte Halbleiterbauteile ist im Stand der Technik prinzipiell bekannt und soll daher nicht erläutert werden.

Um dennoch eine gute Handhabbarkeit des aus dem im Beispiel aus drei Halbleitermodulen 3 aufgebauten Halbleiterbauteils 1 und insbesondere eine gemeinsame Kühlung der Halbleitermodule 3 zu ermöglichen, sind die Halbleitermodule 3 an einem gemeinsamen Tragrahmen 2 angeordnet. DerTragrahmen 2 kann beispielsweise aus einem Blechbauteil oder Ähnlichem gebildet sein, das mehrere Durchbrechungen 6 aufweist. Die Halbleitermodule 3 umfassen jeweils eine Grundplatte 4, die die weiteren Komponenten, also unmittelbar die Halbleiterkomponenten beziehungsweise eine die Halbleiterkomponenten tragendes Substrat, trägt und sind durch eine Vergussmasse 5 vergossen. Die Grundplatte 4 durchgreift die Durchbrechungen 6 jeweils durch Vorsprünge 16, insbesondere Kühlrippen, und liegt auf dem Rand 7 der jeweiligen Durchbrechung 6 auf.

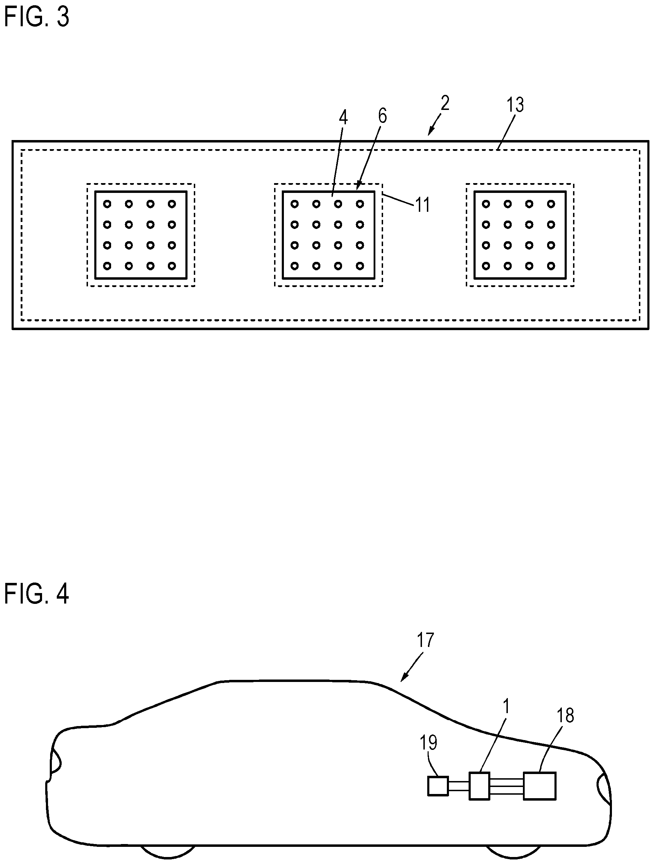

Wie später noch genauer erläutert werden wird, ist an der von den Halbleitermodulen 3 abgewandten Seite des Tragrahmens 2 ein Fluidkanal 20 vorgesehen, durch den beispielsweise flüssiges Kühlmittel geführt werden kann. Um den Fluidkanal 20 abzudichten soll die Grundplatte 4 fluiddicht mit dem Tragrahmen 2 verbunden sein. Dies erfolgt in dem Halbleiterbauteil 1 dadurch, dass die jeweilige Grundplatte 4 mit dem Rand 7 der jeweiligen Durchbrechung 6 des Tragrahmens 2 verlötet ist. Dies wird im Folgenden genauer mit Bezug auf Fig. 2 und 3 erläutert werden.

Fig. 2 zeigt eine vergrößerte Detailansicht des Halbleiterbauteil 1. Wie dort zu erkennen ist, ist zwischen der Grundplatte 4 und den Tragrahmen 2 im Bereich des Randes 7 eine Lot 8 angeordnet, dessen Schmelztemperatur niedriger ist als die Schmelztemperatur des Materials der Grundplatte 4 und des Tragrahmens 2. Um auch bei den bei Halbleiterschaltern teils auftretenden relativ hohen Betriebstemperaturen eine robuste Verbindung sicher zu stellen, wird ein Lot 8 mit einem Schmelzpunkt von wenigstens 450° verwendet, das heißt, es erfolgt ein Hartlöten. Entsprechende Lote sind im Stand der Technik bekannt und sollen nicht detailliert erläutert werden.

Fig. 3 zeigt einen Zwischenschritt im Rahmen der Herstellung des Halbleiterbauteils 1, wobei in diesem Zustand das Verschlusselement 10 noch nicht an dem Halbleiterbauteil 1 angebracht ist und wobei Fig. 3 einen Blick auf die von den Halbleitermodulen 3 abgewandte Seite des Tragrahmens 2 zeigt. Die gestrichelten Linien 11 zeigen jeweils den Abschnitt der Grundplatte 4, in dem die jeweilige Grundplatte 4 mit dem Tragrahmen 2 verlötet ist. Wie in Fig. 3 eindeutig zu erkennen ist, umgreift die Lötnaht beziehungsweise der Abschnitt, in dem eine Verlötung erfolgt, die Durchbrechung 6 beziehungsweise den Bereich, in dem Vorsprünge 16 der Grundplatte 4 die Durchbrechung 6 durchgreifen, vollständig. Somit wird die Durchbrechung 6 durch die Grundplatte 4 und das Lot 8 vollständig abgedichtet.

Die gestrichelte Linie 13 in Fig. 3 zeigt den Bereich, in dem der Tragrahmen 2 mit dem Verschlusselement 10 verlötet wird, um den Kühlkanal 16 auszubilden. Wie in Fig. 2 dargestellt ist, erfolgt somit auch die Verbindung des Tragrahmens 2 mit dem Verschlusselement 10 über ein Lot 12, insbesondere ebenfalls durch Hartlöten. Alternativ könnte diese Verbindung, da sie relativ weit weg von genutzten Halbleiterchips angeordnet ist, auch durch Schweißen erfolgen. Durch das Anbringen des Verschlusselements 10 an dem Tragrahmen 2 und die fluiddichten Verbindungen zwischen Verschlusselemente 10 und Tragrahmen 2 beziehungsweise zwischen Tragrahmen 2 und den Grundplatten 4 durch das jeweilige Lot 8, 12 wird erreicht, dass der Fluidkanal 20 abgesehen von einem Fluidzufluss 14 und einem Fluidabfluss 15 fluiddicht verschlossen ist. Somit können die Vorsprünge 16 beziehungsweise Kühlfinnen beispielsweise in einem verschlossenen Fluidkreislauf von einem flüssigen Kühlmittel umströmt werden.

Das Verlöten der jeweiligen Grundplatten 4 mit dem Tragrahmen 2 beziehungsweise des Tragrahmens 2 mit dem Verschlusselement 10 erfolgt durch Laserlöten. Das Lot 8, 12 kann hierbei vor dem Lötvorgang an einer der Komponenten angeordnet sein oder zwischen diesen angeordnet werden. Anschließend kann Laserlicht in den entsprechenden Bereich eingestrahlt werden, um das Lot 8, 12 zu schmelzen und somit die Komponenten zu verlöten.

Zum Verlöten der Grundplatten 4 an den Tragrahmen 2 wird der Laser von der in Fig. 3 gezeigten Seite des Tragrahmens 2 eingestrahlt, das heißt von unten in Fig. 1. Somit wird der Tragrahmen 2 lokal im Bereich der gestrichelten Linien 11 erhitzt und mit der Erhitzung des Tragrahmens auch das an der anderen Seite des Tragrahmens 2 angeordnete Lot 8 aufgeschmolzen. Es ist vorgesehen, dass die Materialen des Tragrahmens 2 und optional der Grundplatte 4 zumindest lokal angeschmolzen werden, während die Materialien verlötet werden.

Fig. 4 zeigt beispielhaft ein Fahrzeug 17, in dem eine Elektromaschine 18, insbesondere eine Antriebsmaschine des Kraftfahrzeugs 17, durch eine Batterie 19 oder eine andere Gleichspannungsquelle, beispielsweise ein Fahrzeugnetz, versorgt werden soll. Um die Gleichspannung der Batterie 19 beziehungsweise des Fahrzeugnetzes in eine dreiphasige Wechselspannung zum Betrieb der Elektromaschine 18 umzusetzen, wird das in den Figuren 1 und 2 dargestellte Bauteil 1 als Wechselrichter genutzt. Das gleiche Bauteil 1 könnte beispielsweise bei einem Generatorbetrieb der Elektromaschine 18 dazu dienen, die generierte dreiphasige Wechselspannung gleichzurichten, beispielsweise um die Batterie 19 zu laden.

## Patentansprüche

1. Verfahren zur Herstellung eines Halbleiterbauteils (1), umfassend die Schritte:
- Bereitstellen wenigstens eines Halbleitermoduls (3) und eines Tragrahmens (2), der für jedes der Halbleitermodule (3) eine jeweilige Durchbrechung (6) aufweist,
- Anordnen des wenigstens eine Halbleitermoduls (3) an dem Tragrahmen (2) derart, dass eine Grundplatte (4) des jeweiligen Halbleitermoduls auf dem Rand (7) der jeweiligen Durchbrechung (6) aufliegt,
- Verlöten der jeweiligen Grundplatte (4) mit dem Tragrahmen (2), wobei die jeweilige Grundplatte (4) mit einem Lot (8) mit einem Schmelzpunkt von wenigstens 450°C mit dem Tragrahmen (2) verlötet wird,
**dadurch gekennzeichnet,**
**dass** das Verlöten der jeweiligen Grundplatte (4) mit dem Tragrahmen (2) durch Laserhartlöten erfolgt, wobei der Laser hierbei auf die von der Grundplatte (4) abgewandte Seite des Tragrahmens (2) eingestrahlt wird, wodurch der Tragrahmen lokal erhitzt und das Lot durch den erhitzten Tragrahmen aufgeschmolzen wird, wobei im Rahmen des Verlötens der jeweiligen Grundplatte (4) mit dem Tragrahmen (2) das Material des Tragrahmens (2) lokal geschmolzen wird.

2. Verfahren nach Anspruch 1,
**dadurch gekennzeichnet,**
**dass** sich ein Abschnitt der Grundplatte (4), in dem die Grundplatte (4) mit dem Tragrahmen (2) verlötet ist, vollständig um einen Bereich der Grundplatte (4) erstreckt, in dem die Grundplatte (4) Vorsprünge (16) aufweist, die sich durch die jeweilige Durchbrechung (6) des Tragrahmens (2) hindurch erstrecken und vollständig um die jeweilige Durchbrechung (6) des Tragrahmens (2) herum erstreckt.

3. Verfahren nach Anspruch 1 oder 2,
**dadurch gekennzeichnet,**
**dass** durch den Tragrahmen (2), die jeweilige Grundplatte (4) des wenigstens einen Halbleitermoduls (3) und ein Verschlusselement (10) ein Fluidkanal (20) ausgebildet wird, der abgesehen von einem Kühlfluidzufluss (14) und einem Kühlfluidabfluss (15) allseitig fluiddicht verschlossen ist.

4. Verfahren nach Anspruch 3,
**dadurch gekennzeichnet,**
**dass** das Verschlusselement (10) mit dem Tragrahmen (2) verlötet oder verschweißt wird.

5. Verfahren nach einem der vorangehenden Ansprüche,
**dadurch gekennzeichnet,**
**dass** Halbleiterkomponenten des jeweiligen Halbleitermoduls (3) durch Sintern mit der Grundplatte (4) oder einem an der Grundplatte (4) angebrachten Substrat angebracht sind und/oder dass das Halbleitermodul (3) durch eine Vergussmasse (5) vergossen ist.

6. Verfahren nach einem der vorangehenden Ansprüche,
**dadurch gekennzeichnet,**
**dass** der Tragrahmen (2) aus Aluminium oder einer Aluminiumlegierung besteht und/oder dass die Grundplatte (4) aus Kupfer oder Aluminium oder aus einem Verbundmaterial, bei dem Siliziumcarbidpartikel in einer Aluminiummatrix aufgenommen sind, besteht.

7. Verfahren nach einem der vorangehenden Ansprüche,
**dadurch gekennzeichnet,**
**dass** das Halbleitermodul (3) eine Halbbrücke ist und/oder dass das Halbleiterbauteil (1) ein Brückenwechselrichter oder Brückengleichrichter ist.

8. Verfahren nach Anspruch 7,
**dadurch gekennzeichnet,**
**dass** das Halbleiterbauteil (1) ein dreiphasiger Brückenwechselrichter oder Brückengleichrichter ist.

9. Verfahren nach einem der vorangehenden Ansprüche,
**dadurch gekennzeichnet,**
**dass** im Rahmen des Verlötens der jeweiligen Grundplatte (4) mit dem Tragrahmen (2) das Material der Grundplatte (4) lokal geschmolzen wird.

## Claims

1. Method for manufacturing a semiconductor component (1), comprising the steps:
- providing at least one semiconductor module (3) and a support frame (2), which has a respective opening (6) for each of the semiconductor modules (3),
- arranging the at least one semiconductor module (3) on the support frame (2) such that a base plate (4) of the respective semiconductor module rests on the edge (7) of the respective opening (6),
- soldering the respective base plate (4) to the support frame (2), wherein the respective base plate (4) is soldered to the support frame (2) with a solder (8) that has a melting point of at least 450°C,
**characterized in that**
the soldering of the respective base plate (4) to the support frame (2) is performed by laser brazing, wherein the laser is hereby radiated onto that side of the support frame (2) which faces away from the base plate (4), whereby the support frame is heated locally and the solder is melted by the heated support frame, wherein the material of the support frame (2) is locally melted in the course of soldering the respective base plate (4) to the support frame (2).

2. Method according to claim 1,
**characterized in that**
a section of the base plate (4), at which the base plate (4) is soldered to the support frame (2), extends fully around an area of the base plate (4) in which the base plate (4) has projections (16) which extend through the respective opening (6) of the support frame (2) and extends fully around the respective opening (6) of the support frame (2).

3. Method according to claim 1 or 2,
**characterized in that**
a fluid channel (20) is formed by the support frame (2), the respective base plate (4) of the at least one semiconductor module (3) and a closure element (10), which fluid channel apart from a cooling fluid outflow (14) and a cooling fluid outflow (15) is closed in a fluid-tight manner on all sides.

4. Method according to claim 3,
**characterized in that**
the closure element (10) is soldered or welded to the support frame (2).

5. Method according to any one of the preceding claims,
**characterized in that**
semiconductor components of the respective semiconductor module (3) are attached by sintering to the base plate (4) or to a substrate attached to the base plate (4) and/or **in that** the semiconductor module (3) is cast by a casting compound (5).

6. Method according to any one of the preceding claims,
**characterized in that**
the support frame (2) is made of aluminum or an aluminum alloy and/or **in that** the base plate (4) is made of copper or aluminum or of a composite material, in which silicon carbide particles are incorporated into an aluminum matrix.

7. Method according to any one of the preceding claims,
**characterized in that**
the semiconductor module (3) is a half-bridge and/or **in that** the semiconductor component (1) is a bridge inverter or bridge rectifier.

8. Method according to claim 7,
**characterized in that**
the semiconductor component (1) is a three-phase bridge inverter or bridge rectifier.

9. Method according to any one of the preceding claims,
**characterized in that**
in the course of soldering the respective base plate (4) to the support frame (2) the material of the base plate (4) is locally melted.

## Revendications

1. Procédé de fabrication d'un composant semi-conducteur (1) comprenant les étapes suivantes :
- la fourniture d'au moins un module de semi-conducteur (3) et d'un cadre porteur (2) qui présente pour chacun des modules de semi-conducteur (3) une ouverture (6) respective,
- l'agencement de l'au moins un module de semi-conducteur (3) au niveau du cadre porteur (2) de telle manière qu'une plaque de base (4) du module de semi-conducteur respectif repose sur le bord (7) de l'ouverture (6) respective,
- le brasage de la plaque de base (4) respective avec le cadre porteur (2), dans lequel la plaque de base (4) respective est brasée avec une brasure (8) présentant un point de fusion d'au moins 450 °C avec le cadre porteur (2),
**caractérisé en ce que**
le brasage de la plaque de base (4) respective avec le cadre porteur (2) est effectué par brasage dur au laser, dans lequel le laser est ici irradié sur le côté du cadre porteur (2) éloigné de la plaque de base (4), selon lequel le cadre porteur est chauffé localement et la brasure est fondue par le cadre porteur chauffé, dans lequel le matériau du cadre porteur (2) est fondu localement dans le cadre du brasage de la plaque de base (4) respective avec le cadre porteur (2).

2. Procédé selon la revendication 1,
**caractérisé en ce que**
une section de la plaque de base (4), dans laquelle la plaque de base (4) est brasée avec le cadre porteur (2), s'étend complètement autour d'une zone de la plaque de base (4), dans laquelle la plaque de base (4) présente des saillies (16) qui s'étendent à travers l'ouverture (6) respective du cadre porteur (2) et s'étend complètement autour de l'ouverture (6) respective du cadre porteur (2).

3. Procédé selon la revendication 1 ou 2,
**caractérisé en ce que**
un canal de fluide (20) est formé par le cadre porteur (2), la plaque de base (4) respective de l'au moins un module de semi-conducteur (3) et un élément de fermeture (10), canal qui est fermé de manière étanche aux fluides de tous les côtés à l'exception d'un afflux de fluide de refroidissement (14) et d'une évacuation de fluide de refroidissement (15).

4. Procédé selon la revendication 3,
**caractérisé en ce que**
l'élément de fermeture (10) est brasé ou soudé avec le cadre porteur (2).

5. Procédé selon l'une quelconque des revendications précédentes,
**caractérisé en ce que**
des composants semi-conducteurs du module de semi-conducteur (3) respectif sont montés par frittage avec la plaque de base (4) ou un substrat monté au niveau de la plaque de base (4) et/ou **en ce que** le module de semi-conducteur (3) est coulé par une masse de scellement.

6. Procédé selon l'une quelconque des revendications précédentes,
**caractérisé en ce que**
le cadre porteur (2) se compose d'aluminium ou d'un alliage d'aluminium et/ou **en ce que** la plaque de base (4) se compose de cuivre ou d'aluminium ou d'un matériau composite, pour lequel des particules de carbure de silicium sont reçues dans une matrice d'aluminium.

7. Procédé selon l'une quelconque des revendications précédentes,
**caractérisé en ce que**
le module de semi-conducteur (3) est un demi-pont et/ou **en ce que** le composant semi-conducteur (1) est un onduleur en pont ou un redresseur en pont.

8. Procédé selon la revendication 7,
**caractérisé en ce que**
le composant semi-conducteur (1) est un onduleur en pont ou un redresseur en pont triphasé.

9. Procédé selon l'une quelconque des revendications précédentes,
**caractérisé en ce que**
le matériau de la plaque de base (4) est fondu localement dans le cadre du brasage de la plaque de base (4) respective avec le cadre porteur (2).
